(19)

(11) **EP 4 012 525 B1**

(12) **EUROPEAN PATENT SPECIFICATION**

(45) Date of publication and mention of the grant of the patent:
**11.09.2024 Bulletin 2024/37**

(21) Application number: **21201401.3**

(22) Date of filing: **07.10.2021**

(51) International Patent Classification (IPC):
***G05B 23/02*** *(2006.01)*

(52) Cooperative Patent Classification (CPC):
**G05B 23/024; G05B 23/0221;** G05B 23/0283

(54) **METHOD FOR EVENT-BASED FAILURE PREDICTION AND REMAINING USEFUL LIFE ESTIMATION**

VERFAHREN ZUR EREIGNISBASIERTEN AUSFALLVORHERSAGE UND SCHÄTZUNG DER RESTNUTZUNGSDAUER

PROCÉDÉ DE PRÉDICTION DE DÉFAILLANCE BASÉE SUR DES ÉVÉNEMENTS ET D'ESTIMATION DE LA DURÉE DE VIE UTILE RESTANTE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **10.12.2020 US 202017118081**

(43) Date of publication of application:
**15.06.2022 Bulletin 2022/24**

(73) Proprietor: **Hitachi, Ltd.**
**Tokyo 100-8280 (JP)**

(72) Inventors:
- **SHALABY, Walid**
  **Santa Clara, 95054 (US)**
- **ALAM, Mahbubul**
  **Santa Clara, 95054 (US)**
- **GHOSH, Dipanjan**
  **Santa Clara, 95054 (US)**
- **FARAHAT, Ahmed**
  **Santa Clara, 95054 (US)**
- **GUPTA, Chetan**
  **Santa Clara, 95054 (US)**

(74) Representative: **Strehl Schübel-Hopf & Partner**
**Maximilianstrasse 54**
**80538 München (DE)**

(56) References cited:

| | |
|---|---|
| **EP-A1- 3 407 267** | **WO-A1-2018/071005** |
| **US-A1- 2016 239 756** | **US-A1- 2018 356 151** |
| **US-A1- 2019 235 484** | **US-A1- 2020 210 824** |

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Processed by Luminess, 75001 PARIS (FR)

## Description

## BACKGROUND

### Field

The present disclosure is generally directed to machine learning implementations, and more specifically, for learning predictive models for failure prediction and remaining useful life (RUL) estimation on event-based sequential data.

### Related Art

Prognostics involve the prediction of future health, performance, and any potential failures in equipment. Prognostics techniques are applied in the related art when a fault or degradation is detected in the unit to predict when a failure or severe degradation will happen. The problem of predicting a failure or estimating the remaining useful life of an equipment has been extensively studied in the Prognostics and Health Management (PHM) research community.

Failure Prediction (FP) involves predicting whether a monitored unit will fail within a given time horizon. The prediction methods receive the raw measurements from the unit as input and produce the probability of a certain failure type as output. For different failure types, multiple models can be constructed. If there are many failure examples, classification models can be learned from the data to distinguish between failure and non-failure cases.

On the other hand, Remaining Useful Life (RUL) estimation is concerned with estimating how much time or how many operating cycles are left in the life of the unit till a failure event of a given type happens. The prediction methods receive the raw measurements from the unit as input and produce a continuous output that reflects the remaining useful life (e.g., in time or operating cycle units).

If there are many run-to-failure examples, the RUL problem can be formulated as a regression problem. In the related art, several regression-based approaches have been used to solve the RUL problem such as neural networks, Hidden Markov Models, and similarity-based methods. Recently, many deep learning models have been applied to the RUL problem. For instance, Deep Convolutional Neural Network (CNN) applies the convolution and pooling filters along the temporal dimension over the multi-channel sensor data. Long Short-Term Memory (LSTM) uses multiple layers of LSTM cells in combination with standard feed forward layers to discover hidden patterns from sensor and operational data.

Although related art implementations have involved learning predictive models for failure prediction (FP) and remaining useful life (RUL) time estimation on regularly sampled continuous sensor measurements, event-based FP and RUL have not been considered widely. Most of the existing techniques for RUL are designed to work on cases where the available data are multivariate time-series of sensor measurements that were recorded before failures. For most of the equipment, such sensor measurements are not available. Instead, most of equipment control units record and communicate events that reflect important changes in the underlying sensors (e.g., an event to reflect high pressure or low temperature) instead of maintaining the raw sensor measurements every few seconds (e.g., pressure and temperature measures). These events are typically defined by the equipment designers to summarize many raw signals and encode the important domain knowledge that needs be communicated to the equipment users and repair technicians. In addition, for Internet of Things (IoT) solutions, managing these events instead of raw sensor measurements significantly reduces storage and communication costs. For these types of equipment, related art techniques for RUL estimation will not be able to handle discrete events and are not designed to benefit from the domain knowledge encoded in such events.

US 2020/210824 A1 discloses a scalable system for forecasting wind turbine failure and forms the basis for the two-part form of present claim 6. Other conventional failure predicting systems are described in US 2016/239756 A1, US 2018/356151 A1, EP 3 407 267 A1, WO 2018/071005 A1, and US 2019/235484 A1.

## SUMMARY

Unlike traditional time series data of sensor measurements (typically continuous values), event-based sequential data is composed of sequence of nominal values (events). In addition, event-based sequential data is irregularly sampled which means there are no fixed time intervals between events within the input sequence. Moreover, event-based sequential data is different from language/text. Though textual data is composed of nominal values (i.e., words), these words follow strict order based on the language grammar. With event-based sequential data, in many scenarios, there are floating events which might appear anywhere within the sequence causing high variability in the sequence order. All these key differences pose unique challenges when modeling event-based sequential data.

Additionally, in most cases, there will be limited instances of failure sequences. Training a machine learning model with small amounts of datas might cause overfitting and poor generalizations, hence data augmentation techniques are necessary to address such data scarcity problems.

The present invention solves the above-explained problems by the features defined in the independent claims.

The subclaims relate to preferred embodiments.

Example implementations described herein involve a methodology for failure prediction and remaining useful life (RUL) estimation on event-based sequential data. The example implementations include: 1) Techniques for data augmentation to handle scarcity of event-based failure data, 2) A feature extraction module for extracting features from raw data and aggregate event features for each event from the event-based failure sequence, 3) Learnable neural network-based attention mechanisms for failure prediction or predicting time to failure using event-based failure sequences, 4) A data-adaptive optimization framework for adaptively fitting original vs. synthetic data, 5) A cost-sensitive optimization framework for prioritizing predictions of costly failures, and 6) A pipeline for preprocessing event-based sequences.

## BRIEF DESCRIPTION OF DRAWINGS

FIG. 1 illustrates a flow diagram of our methodology for RUL of event-based sequential data, in accordance with an example implementation.

FIG. 2 illustrates an example of generating subsequences from a sequence by using a sliding window, in accordance with an example implementation.

FIG. 3 illustrates an example flow diagram for the LSTM based failure prediction model, in accordance with an example implementation.

FIG. 4 illustrates an example flow diagram for the multi-head attention model, in accordance with an example implementation.

FIG. 5 illustrates an example flow diagram for the ensemble model, in accordance with an example implementation.

FIG. 6 illustrates a system involving a plurality of systems with connected sensors and a management apparatus, in accordance with an example implementation.

FIG. 7 illustrates an example computing environment with an example computer device suitable for use in some example implementations.

## DETAILED DESCRIPTION

The following detailed description provides details of the figures and example implementations of the present application. Reference numerals and descriptions of redundant elements between figures are omitted for clarity. Terms used throughout the description are provided as examples and are not intended to be limiting. For example, the use of the term "automatic" may involve fully automatic or semi-automatic implementations involving user or administrator control over certain aspects of the implementation, depending on the desired implementation of one of ordinary skill in the art practicing implementations of the present application. Selection can be conducted by a user through a user interface or other input means or can be implemented through a desired algorithm. Example implementations as described herein can be utilized either singularly or in combination and the functionality of the example implementations can be implemented through any means according to the desired implementations.

The key contributions of the methodology for failure prediction and remaining useful life (RUL) estimation on event-based sequential data include feature extraction from raw features and aggregate other event features for each event from the failure sequence. Raw features include the time of the event and how far the event from the failure. This distance can be expressed in terms of time scale (e.g., months, weeks, days, hours, minutes, or seconds) or operating cycles scale (e.g., X miles from failure). Aggregate event features include how many times the event has appeared within the sequence, for how long it has been active, how far it is from the previous event whether it the same type or different. All these event-specific features are blended together and used to create a multivariable vector representation for each event within the sequence.

Example implementations also include data augmentation to handle the scarcity of event-based failure data. In most cases, there will be limited instances of failure sequences. Training a machine learning model with such small amount of data might cause overfitting and poor generalization. In order to address this data scarcity problem, example implementations involve various techniques for augmenting the data with semantically similar failure samples. Formally, given $n$ categories of equipment whose failure sequences are $E = \{E_1,...,E_n\}$, distance to failure sequences $F = \{F_i,...,F_n\}$

, a labeling function $L$ to map $D$ to buckets, and a target equipment i, then the training data $D^{train}$ for equipment categories will be obtained by combining training sequences of all categories as follows:

$$D^{train} = \bigcup_{i=1}^{n} E_i^{train}$$

Training labels will be obtained by applying target equipment-specific buckets on $F$ sequences of all equipment categories:

$$Y_i^{train} = L_{buckets_i}\left(\bigcup_{j=1}^{n} F_j^{train}\right)$$

Testing data $D^{test}$ will be obtained from target equipment testing sequences as follows:

$$D^{test} = E_i^{test}$$

Testing labels will be obtained as follows:

$$Y_i^{test} = L_{buckets_i}(F_i^{test})$$

Example implementations involve techniques for data augmentation to increase the diversity of data available for training and to improve the machine learning model generalization. To this end, example implementations involve various techniques for augmenting the data with synthetic samples from the available samples using: 1) dropout of events/subsequences within the sequence, 2) random injection of events/subsequences within the sequence, random shuffling/permutations of events/subsequences, 3) random variation in continuous features (e.g., distance) such that data distribution is maintained (mean and variance), and 4) value swap from nearby events/subsequences (e.g., swap distance values within context window).

To extract different kinds of relationships between the events within the sequence (e.g., escalation of an event, cascading effects, etc.), learnable neural network-based attention mechanisms are utilized in example implementations. The attention mechanism allows focusing on relevant events to the prediction within the sequence and discarding irrelevant ones. Two example implementations of this attention-based relation extraction method are Long Short-Term Memory (LSTM) units with attention mechanism, and multi-head self-attention model.

To learn better representation of floating events which might appear anywhere within the sequence, causing high variability in the sequence order, the neural network-based attention model is fed with two sequences: 1) a sequence of events where the event order is maintained using positional encodings, and 2) another sequence where order information are not encoded within the sequence.

Example implementations involve a method for data-adaptive optimization framework for adaptively fitting original vs. synthetic/augmented data. Original failure sequences are assumed to have stronger predictive patterns than synthetic and augmented samples. Therefore, a weighted sum of losses is utilized within the optimization procedure to assign higher loss to original sequences compared to synthetic and augmented ones. Formally, given loss of original sequences $L_o$, loss of augmented sequences $L_a$, and loss of synthetic sequences $L_s$, then the overall loss can be computed as: $L = \alpha L_o + \beta L_a + \gamma L_a$, where the weights $\alpha$, $\beta$, and $\gamma$ can be learned or fine-tuned empirically.

Example implementations involve a method for cost-sensitive optimization framework for prioritizing predictions of costly failures. This can also be based on the time, type, category, or component of the failure. A weighted sum of losses is utilized within the optimization procedure to assign higher loss to costly or time-consuming failures compared to less expensive and quick to repair failures. Again, the weights can be learned or fine-tuned empirically.

Example implementations involve a pipeline for preprocessing event-based sequences. The pipeline retrieves event data from tabular data sources and converts it into sequences of events where each sequence represents event-based failure sequence.

Event-based Remaining Useful Life (RUL) estimation is a task which in machine learning context, can be formulated as a regression problem in which a continuous estimate of RUL is produced. In the context of RUL, the output of a regression algorithm is difficult to evaluate by a domain expert, hence, the RUL estimation problem is formulated as a classification problem by bucketizing the raw RUL values into a set of ranges provided by domain experts to enable the operationalization of the predicted RUL.

Without loss of generality, the methodology to estimate the RUL is explained with respect to vehicles; specifically, estimating how many miles the vehicle will run until failure given emitted fault codes as input. The same methods and techniques described herein can also be applied to estimate RUL for other equipment where: 1) the target output is some operating unit until failure (e.g., operating cycles, time, etc.), and 2) the input is sequence of event data collected before the failure (e.g., error messages, system codes, etc.). In the context of vehicle breakdown, example implementations learn a function *F(X)=y* where *x={Vehicle equipment information, Fault code events, Mileage usage information, Operating condition}*, and *y='Miles distance to failure'.* The inputs to this function are equipment information (e.g., truck size, make, model, year, etc.), events from different equipment components (e.g. fault codes emitted by a truck), equipment usage information (e.g., mileage or operating hours), and operating condition data (e.g., duty cycle category of a truck which could be a function of engine up time and travelled distance), and other sensor data. The output of the function is the distance to failure in terms of time or operating cycles.

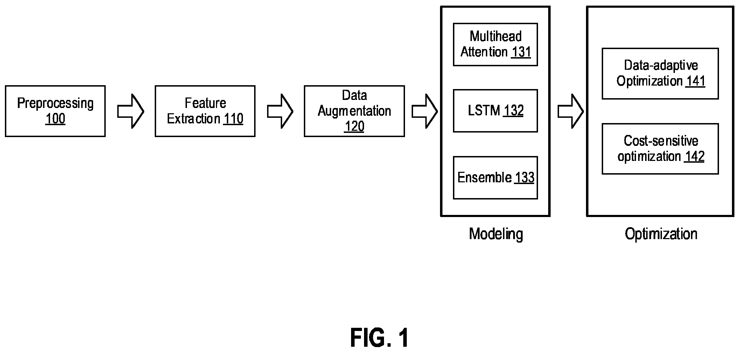

FIG. 1 illustrates a flow diagram of our methodology for RUL of event-based sequential data, in accordance with an example implementation. Each step is described in detail as follows.

The data preprocessing 100 performs the following operations: fetch failure related data from a database of historical failures, join records from different data sources to augment each event with the relevant attributes, and transform data from tabular to sequence format for model training. From executing all of the preprocessing steps 100, a dataset of failure samples is obtained. Each sample involves a sequence of events (fault codes - FCs), ordered by the event trigger time, which can also include information indicative of event distance from failure (in time or operating cycles) with an FC Event component code (FC-CC) which is a subcomponent within the equipment that triggered that FC event, and usage information reading when the event was triggered.

For the feature extraction 110, performance degradation of any equipment depends on its physical properties and on how it operates (i.e., its workload). This is referred to as the equipment operating conditions and the equipment is divided into categories based on their operating conditions. Since the task is to predict a distance-to-failure bucket for each event, different bucket boundaries are defined for each operating condition (OC) category. In one example implementation, boundaries could be set for each operating condition to allow prediction of failure within time (e.g., 1 day, 1 week, 2 weeks, 3 weeks, and so on).

The RUL model is expected to make a prediction for each new event. In other words, for each sequence of length N, the model should produce a prediction for each event within the sequence, hence there will be *N* samples to generate from the sequence and feed to the model subsequently. Several strategies for sequence generations are available here including but not limited to,

*LAST*: Using last event only, without keeping track of event history prior to last event.

$WND_{S,N}$: Using a sliding window of fixed size *S*, and moving it *N* steps at a time to generate *N* subsequences. Here, *N* can be parametrized by time, mileage, number, etc. As the model produces a prediction for each event, *N* is set to 1.

$WND\text{-}BOW_{S,N}$: Same as $WND_{S,N}$, but treating events within the subsequence as bag-of-events without maintaining their order.

For each event, the following are computed: 1) distance since the event first appeared in the sequence, 2) distance the event has been on in the sequence (i.e., unit miles for far - miles since first occurrence), and 3) distance from the previous event in the sequence. Moreover, each event has a corresponding distance to failure value which is bucketized and labeled with a target label. The aforementioned features are considered as sequence features as they occur along with the sequence of fault code events. Additionally, some important unit attributes are considered such as its model, make, year, engine size, etc. as non-sequence (time-independent) features. These features are same for all the events in the sequence since all the events in that sequence are obtained from the same unit. Therefore, there is a combination of sequence and non-sequence features to feed into the deep learning models.

The sequence of events is similar to words in sentences. As such, events are translated to some integer values and use embedding mechanism similar to the one found in language models to convert the events to feature vectors. The event count feature is converted to one hot vector. Other sequence features inferred from equipment usage (distance since the fault code first appeared, distance the fault code has been, distance from the previous fault code) are numerical; therefore, an appropriate feature normalization technique is applied. The non-sequence unit related features are also one hot encoded.

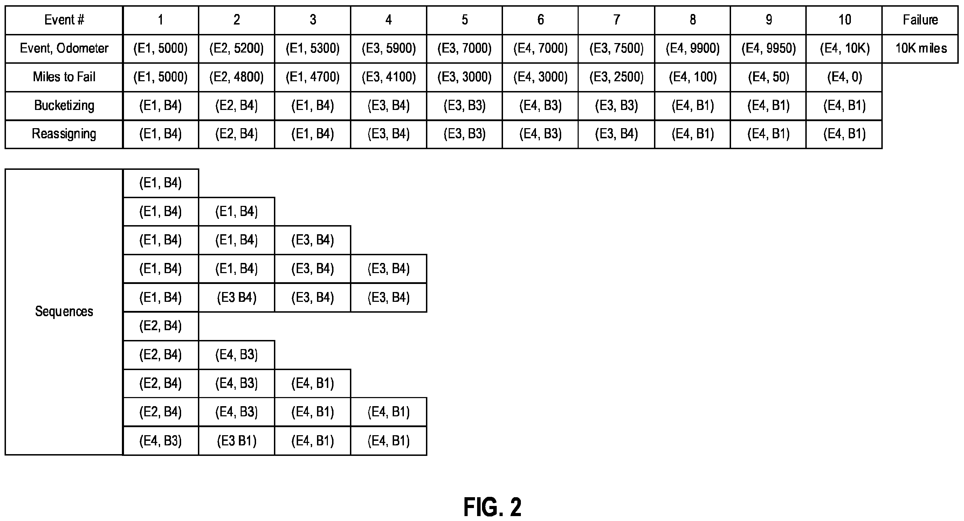

FIG. 2 illustrates an example of generating subsequences from a sequence by using a sliding window, in accordance with an example implementation. Specifically, FIG. 2 illustrates generating subsequences from sequence using a sliding window of size 4 with step of length 1 ($WND_{4,1}$). Events *E1*/*E3* and *E2*/*E4* belong to two different components with bucket boundaries as follows:

| B1: < *'m1'* miles | B2: *'m1'-'m2'* miles | B3: *'m2'-'m3' miles* | B4: > *'m3'* miles |
|---|---|---|---|

In the example of FIG. 2, the implementations place more importance on original data versus the synthetic data and cost-sensitive loss function can be applied based on the importance of the events. In FIG. 2, *E1* and *E2* are actual events with corresponding values of the event occurrence. In this specific example, event *E1* occurred at the odometer 5,000 miles. According to the analytics, this means the failure may occur in another 5000 miles (FIG.2, top table, row "Miles to Fail"). Subsequently, when the *E2* event occurs at the 5,200 mile mark on the odometer, the analytics indicates that the failure may happen within 4,800 miles and so on.

In example implementations, bucketization is employed based on the bucket boundaries as noted above. Accordingly, events *E1* and *E2* are placed in the bucket 4 category. The data is organized in a way in which if there are ordered sequences, the sequences are broken into increments. In an example, for the occurrence of events *E1, E2, E3* and *E4*, the events are broken into a sequence in which only *E1* is in the first sequence, the next sequence has events *E1* and *E2*, the next sequence has events *E1*, *E2*, and *E3*, and so on. In this way, more data samples can be obtained, and it allows the machine learning model to intake the data without concern for the order of the sequence.

For data augmentation 120, given a dataset with N different types of units categorized based on the operating condition. For trucks, the operating conditions reflect the duty cycle which determines the size of the unit and determines how many miles the unit usually drives. For example, a long-haul unit usually puts more mileage compared to a small city unit. Therefore, it is necessary to define the buckets based on the operating condition (e.g., vehicle's duty cycle). Accordingly, the data is divided into *N* subsets where each subset has its own ground truth. By doing this, the number of data samples in different subsets becomes very scarce. Training a deep learning model with such small amount of data might cause overfitting and poor generalization. In order to address this data scarcity problem, data augmentation 120 is conducted. The purpose of data augmentation 120 is to increase the amount of data available for model training by adding semantically similar samples. Formally, given n duty cycle categories whose failure sequences are $DC = \{DC_1, \ldots, DC_n\}$, miles distance to fail sequences $MTF = \{MTFi, \ldots, MTF_n\}$ a labeling function *L* to map *MTF* to buckets, and a target duty cycle *i*, then the training data $D^{train}$ for all operating conditions will be obtained by combining training sequences of all operating conditions as follows:

$$D^{train} = \bigcup_{i=1}^{n} DC_i^{train}$$

Training labels will be obtained by applying target operating condition buckets on MTF sequences of all operating condition categories:

$$Y_i^{train} = L_{buckets_i}\left(\bigcup_{i=1}^{n} MTF_i^{train}\right)$$

Testing data $D^{test}$ will be obtained from target operating condition testing sequences as follows:

$$D^{test} = DC_i^{test}$$

Testing labels will be obtained as follows:

$$Y_i^{test} = L_{buckets_i}\left(MTF_i^{test}\right)$$

Additionally, the bucketization step assigns the continuous distance to failure value to the appropriate class based on the operating condition category. This in turn creates a severe class imbalance problem. In order to prevent the deep learning models from overfitting, oversampling and weighted loss techniques are applied as follows.

Oversampling: An oversampling technique is applied to the data points that belongs to the under sampled class. Essentially, the data points belonging to the under sampled class are randomly duplicated to match the number of points belonging to the class that has the maximum value. Though this may not entirely resolve the class imbalance issue, the oversampling technique may reduce the overfitting problem of deep learning models.

Weighted Loss: As an alternative to applying oversampling, a weighted loss technique can also be implemented to alleviate the class imbalance problem. Conventional loss functions enforce equal weight to each training example without considering whether the example belongs to dominant class or rare one. This is not desirable in our case since there is a reasonable imbalanced class distribution. Consequently, the weighted loss technique is applied, where the data is balanced by altering the weight for each training example when computing the loss.

In addition, to increase the diversity of data available for training and to improve the machine learning model generalization, various techniques are implemented for augmenting the data with synthetic samples from the available samples using: 1) dropout of events/subsequences within the sequence, 2) random injection of events/subsequences within the sequence, random shuffling/permutations of events/subsequences, 3) random variation in continuous features (e.g., distance) such that data distribution is maintained (mean and variance), and 4) value swap from nearby events/subsequences (e.g., swap distance values within context window).

For modeling, there are three example implementations for RUL using deep learning: Multi-head attention model 131, Long-Short-Term-Memory (LSTM) 132, and Ensemble model 133. The following outlines examples for each model.

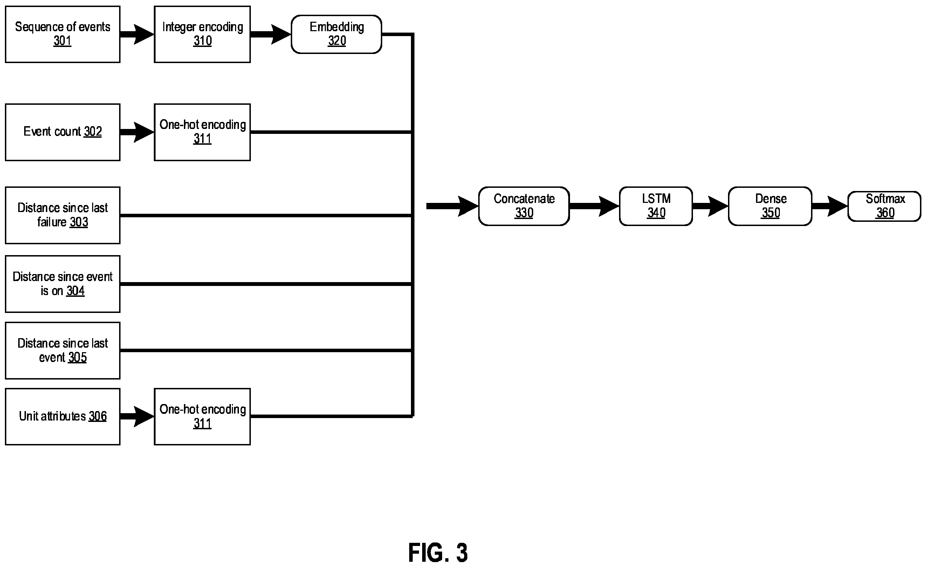

FIG. 3 illustrates an example flow diagram for the LSTM based failure prediction model 132, in accordance with an example implementation. Specifically, a high-level flow diagram of the LSTM based failure prediction model 132 is shown in FIG. 3. Each time step of the LSTM input unit considers a single event type 300 and the corresponding count 301, distance since last failure 302, distance the fault code has been on 303, distance since last fault code 304 and all the unit attributes 305 of the unit as inputs. The sequence of events 300 are encoded via integer encoding 310 and then processed through an embedding process 320 to be processed by concatenation 330. Event count 301 and unit attributes 305 can be encoded via one-hot encoding 311. These features are concatenated 330 to one single vector before feeding to the LSTM input layer 340. The output of the last time step of the LSTM is fed into a dense layer 350 followed by a softmax classification layer 360 to assign a label (bucket) to the given sequence. The LSTM model is trained by minimizing the categorical cross entropy loss using an optimizer such as Nesterov Adaptive Moment estimation (NADAM).

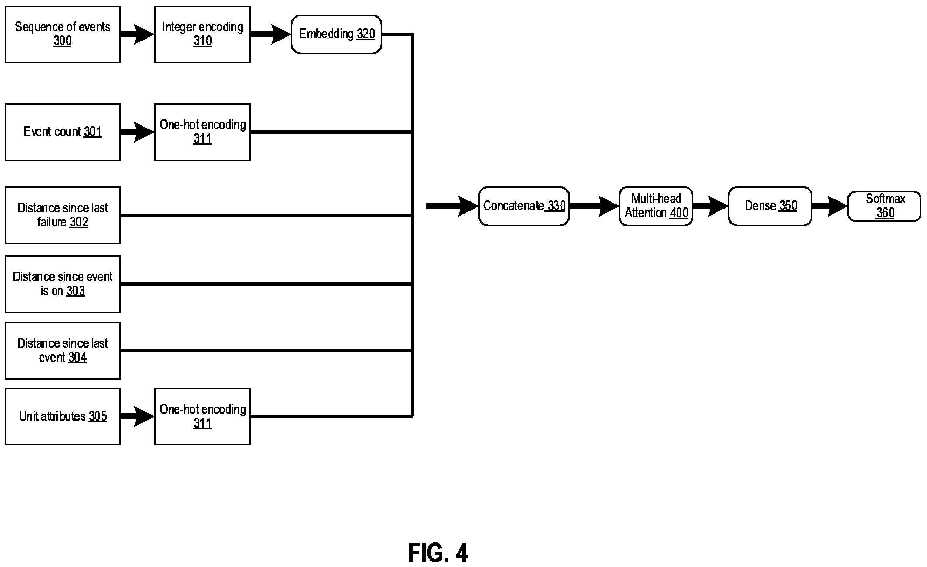

FIG. 4 illustrates an example flow diagram for the multi-head attention model 131, in accordance with an example implementation. The multi-head attention model 131 is a recently introduced technique which has shown state-of-the-art performance in language translation tasks. The main advantage of the multi-head attention model 400 is the ability to handle data at different time steps in parallel. This significantly reduces the computation time compared to the conventional recurrent models such as LSTM where the computation of one a time-step depends on the previous one. Moreover, the multi-head attention model 400 can capture longer time dependencies compared to the LSTM. Additionally, the multi-head attention model 400 can capture multiple relationships between events at different time steps by taking advantage of its multiple heads. The multi-head attention model is trained by minimizing the categorical cross entropy loss using an optimizer such as Adaptive Moment estimation (ADAM).

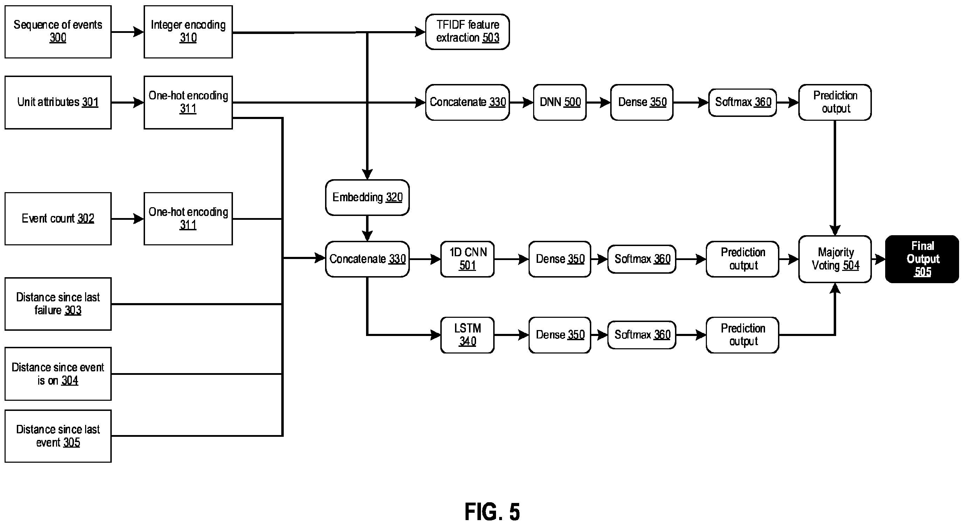

FIG. 5 illustrates an example flow diagram for the ensemble model 133, in accordance with an example implementation. Specifically, FIG. 5 illustrates an example flow diagram of an ensemble model 133 to solve the RUL task. The main advantage of ensemble model is that different models capture different features from the data, and subsequently, improves the overall performance when combined. The ensemble model utilized in this experiment is inspired by a model called randomized multi-model deep learning (RMDL). The RMDL is essentially a combination of multiple randomized deep learning models such as deep feed-forward neural networks (DNNs), convolutional neural networks (CNNs), and LSTM networks. The RMDL model is shown to be effective for both text and image data.

The ensemble model utilizes three deep learning models: deep neural networks (DNNs) 500, 1D CNNs 501 and LSTMs 340. The input to the DNN models is different from the other two as DNNs cannot handle time dependent data. Therefore, term frequency-inverse document frequency (TFIDF) features are extracted 503 from the integer encoded fault code sequences. Next, the TFIDF features 503 with the one-hot encoded unit attributes 311 are concatenated and fed to the DNN model. Note that the DNN model 500 does not consider other sequence features such as miles since last failure, miles since fault code is on and miles since last fault code. Conversely, both the ID CNN 501 and LSTM model 340 considers all the features similar to the LSTM 340 and multi-head attention model as mentioned in the previous two sections. The ensemble model is trained as follows:

Step 1) Set a range of hyper-parameter values such as number of layers, number of hidden nodes, optimizers for the DNN model.

Step 2) Generate a random number from the range of values and design an appropriate DNN model based on these values.

Step 3) Train the DNN model and save the model weights for prediction.

Step 4) Repeat steps 1-3 "*n*" times (*n* is set in accordance with the desired implementation).

Step 5) Repeat steps 1-4 for the CNN and LSTM model.

Once the training is done, the testing is performed by obtaining predictions from all the trained DNN, CNN and LSTM models using the test data, storing the prediction results, and performing a majority voting technique 504 in the stored prediction results to obtain the final prediction result 505.

For the optimization, the proposed event-based RUL methodology implements an optimization framework which is: 1) data-adaptive 141 for adaptively fitting original versus synthetic data, and 2) cost-sensitive 142 for prioritizing predictions of costly failures.

Example implementations involve a data-adaptive optimization framework 141 for adaptively fitting original vs. synthetic data. Original failure sequences are assumed to have stronger predictive patterns than synthetic and augmented samples. Therefore, the weighted-sum of losses is utilized within the optimization procedure to assign higher loss to original sequences compared to synthetic and augmented ones. Formally, given loss of original sequences $L_o$, loss of augmented sequences $L_a$, and loss of synthetic sequences $L_s$ then the overall loss can be computed as: $L = \alpha L_o + \beta L_a + \gamma L_a$, where the weights $\alpha$, $\beta$, and $\gamma$ can be learned or fine-tuned empirically.

Additionally, example implementations involve methods for a cost-sensitive optimization framework 142 for prioritizing predictions of costly failures. This can also be based on the time, type, category, or component of the failure. Weighted-sum of losses is utilized within the optimization procedure to assign higher loss to costly or time consuming failures compared to less expensive and quick to repair failures. Again, the weights can be learned or fine-tuned empirically.

Example implementations can be utilized in applications which require prediction of remaining useful life estimation and failure prediction of equipment based on event-based sequential data.

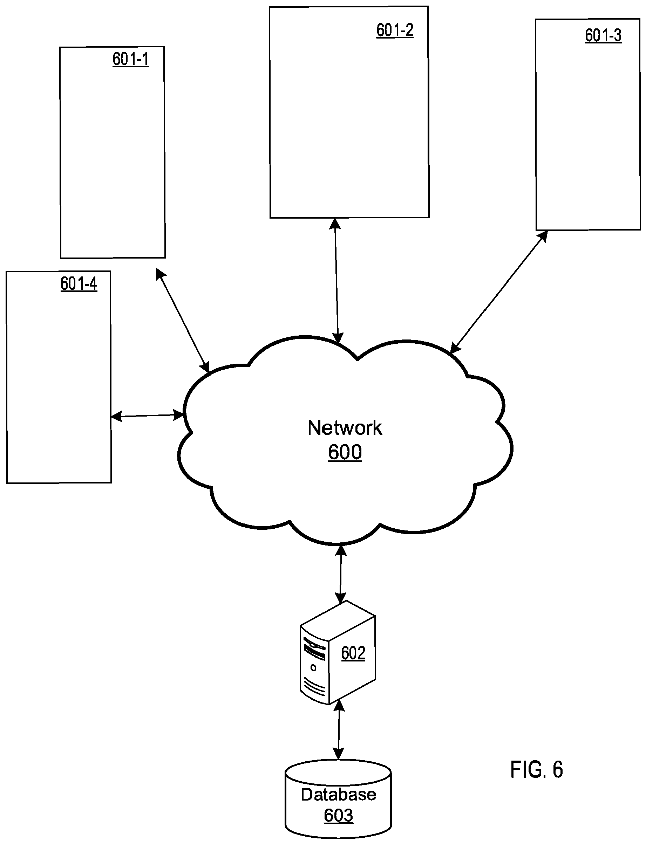

FIG. 6 illustrates a system involving a plurality of systems with connected sensors and a management apparatus, in accordance with an example implementation. One or more systems with connected sensors 601-1, 601-2, 601-3, and 601-4 are communicatively coupled to a network 600 which is connected to a management apparatus 602, which facilitates functionality for an Internet of Things (IoT) gateway or other manufacturing management system. The management apparatus 602 manages a database 603, which contains historical data collected from the sensors of the systems 601-1, 601-2, 601-3, and 601-4. In alternate example implementations, the data from the sensors of the systems 601-1, 601-2, 601-3, 601-4 and can be stored to a central repository or central database such as proprietary databases that intake data such as enterprise resource planning systems, and the management apparatus 602 can access or retrieve the data from the central repository or central database. Such systems can include robot arms with sensors, turbines with sensors, lathes with sensors, and so on in accordance with the desired implementation. Examples of sensor data can include data from vehicles as illustrated in FIG. 2, air pressure/temperature in air compressors, and so on depending on the desired implementation.

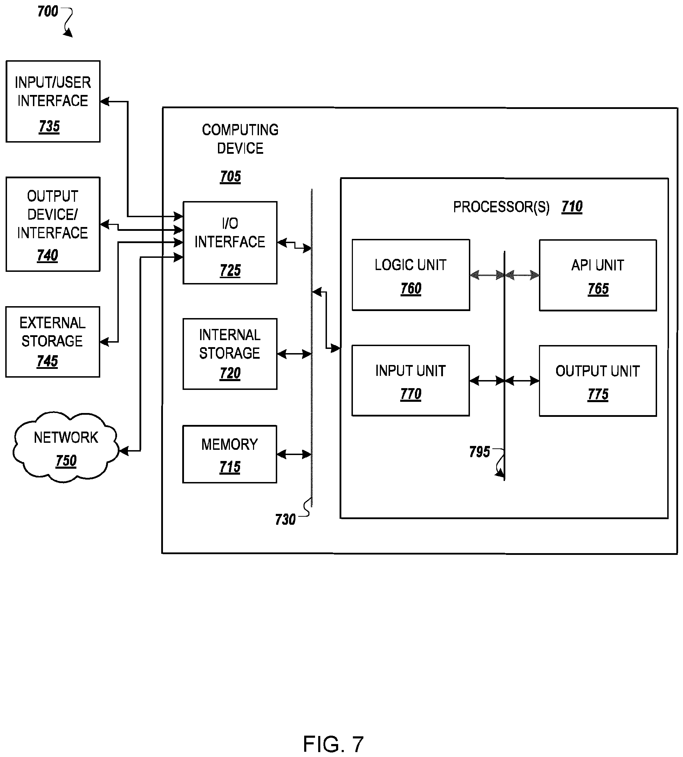

FIG. 7 illustrates an example computing environment with an example computer device suitable for use in some example implementations, such as a management apparatus 602 as illustrated in FIG. 6.

Computer device 705 in computing environment 700 can include one or more processing units, cores, or processors 710, memory 715 (e.g., RAM, ROM, and/or the like), internal storage 720 (e.g., magnetic, optical, solid state storage, and/or organic), and/or I/O interface 725, any of which can be coupled on a communication mechanism or bus 730 for communicating information or embedded in the computer device 705. I/O interface 725 is also configured to receive images from cameras or provide images to projectors or displays, depending on the desired implementation.

Computer device 705 can be communicatively coupled to input/user interface 735 and output device/interface 740. Either one or both of input/user interface 735 and output device/interface 740 can be a wired or wireless interface and can be detachable. Input/user interface 735 may include any device, component, sensor, or interface, physical or virtual, that can be used to provide input (e.g., buttons, touch-screen interface, keyboard, a pointing/cursor control, microphone, camera, braille, motion sensor, optical reader, and/or the like). Output device/interface 740 may include a display, television, monitor, printer, speaker, braille, or the like. In some example implementations, input/user interface 735 and output device/interface 740 can be embedded with or physically coupled to the computer device 705. In other example implementations, other computer devices may function as or provide the functions of input/user interface 735 and output device/interface 740 for a computer device 705.

Examples of computer device 705 may include, but are not limited to, highly mobile devices (e.g., smartphones, devices in vehicles and other machines, devices carried by humans and animals, and the like), mobile devices (e.g., tablets, notebooks, laptops, personal computers, portable televisions, radios, and the like), and devices not designed for mobility (e.g., desktop computers, other computers, information kiosks, televisions with one or more processors embedded therein and/or coupled thereto, radios, and the like).

Computer device 705 can be communicatively coupled (e.g., via I/O interface 725) to external storage 745 and network 750 for communicating with any number of networked components, devices, and systems, including one or more computer devices of the same or different configuration. Computer device 705 or any connected computer device can be functioning as, providing services of, or referred to as a server, client, thin server, general machine, special-purpose machine, or another label.

I/O interface 725 can include, but is not limited to, wired and/or wireless interfaces using any communication or I/O protocols or standards (e.g., Ethernet, 802.11x, Universal System Bus, WiMax, modem, a cellular network protocol, and the like) for communicating information to and/or from at least all the connected components, devices, and network in computing environment 700. Network 750 can be any network or combination of networks (e.g., the Internet, local area network, wide area network, a telephonic network, a cellular network, satellite network, and the like).

Computer device 705 can use and/or communicate using computer-usable or computer-readable media, including transitory media and non-transitory media. Transitory media include transmission media (e.g., metal cables, fiber optics), signals, carrier waves, and the like. Non-transitory media include magnetic media (e.g., disks and tapes), optical media (e.g., CD ROM, digital video disks, Blu-ray disks), solid state media (e.g., RAM, ROM, flash memory, solid-state storage), and other non-volatile storage or memory.

Computer device 705 can be used to implement techniques, methods, applications, processes, or computer-executable instructions in some example computing environments. Computer-executable instructions can be retrieved from transitory media and stored on and retrieved from non-transitory media. The executable instructions can originate from one or more of any programming, scripting, and machine languages (e.g., C, C++, C#, Java, Visual Basic, Python, Perl, JavaScript, and others).

Processor(s) 710 can execute under any operating system (OS) (not shown), in a native or virtual environment. One or more applications can be deployed that include logic unit 760, application programming interface (API) unit 765, input unit 770, output unit 775, and inter-unit communication mechanism 795 for the different units to communicate with each other, with the OS, and with other applications (not shown). The described units and elements can be varied in design, function, configuration, or implementation and are not limited to the descriptions provided.

In some example implementations, when information or an execution instruction is received by API unit 765, it may be communicated to one or more other units (e.g., logic unit 760, input unit 770, output unit 775). In some instances, logic unit 760 may be configured to control the information flow among the units and direct the services provided by API unit 765, input unit 770, output unit 775, in some example implementations described above. For example, the flow of one or more processes or implementations may be controlled by logic unit 760 alone or in conjunction with API unit 765. The input unit 770 may be configured to obtain input for the calculations described in the example implementations, and the output unit 775 may be configured to provide output based on the calculations described in example implementations.

Processor(s) 710 can be configured to predict failures and remaining useful life (RUL) for equipment through the execution of the flows and examples of FIGS. 1-5. In an example, processor(s) 710 can be configured to, for data received from the equipment comprising fault events, conduct feature extraction on the data to generate sequences of event features based on the fault events as illustrated at 100 and 110 of FIG. 1; apply deep learning modeling to the sequences of event features to generate a model configured to predict the failures and the RUL for the equipment based on event features extracted from data of the equipment as illustrated in modeling of FIG. 1 and by FIGS. 3-5; and execute optimization on the model as illustrated by optimization of FIG. 1.

Processor(s) 710 can be configured to execute data augmentation on the data, the data augmentation configured to generate additional semantically similar data samples based on the data; wherein the optimization is data-adaptive optimization configured to weigh ones derived from data received from the equipment higher than ones derived from the semantically similar data samples for the prediction of the failures and the RUL for the equipment as illustrated at 120 of FIG. 1.

In example implementations, the deep learning modeling can involve learnable neural network-based attention mechanisms configured to determine relevant ones of the event features within the sequences of event features and discarding less relevant ones of the event features as described with respect to FIG. 5.

In example implementations, the deep learning modeling can be one of multi-head attention 131, Long Short Term Memory (LSTM) 132, and ensemble modeling 133 and as illustrated in FIGS. 3-5.

In example implementations, the optimization of the model is cost sensitive optimization configured to weigh predictions of failures to be higher based on cost as illustrated at 142 of FIG. 1.

Processor(s) 710 can be configured to execute the model on the data received from the equipment; and control operation of the equipment based on the predicted failures and RUL. In an example implementation, processor(s) 710 can be configured to schedule resets into safe modes for equipment, force a shutdown of the equipment, activate andons based on the type of predicted failure and RUL, or otherwise configure the equipment based on the predicted failures and RUL. In an example implementation, predicted failures and RUL can be mapped to an action to be invoked on the equipment by processor(s) 710, which can be set to any desired implementation.

Some portions of the detailed description are presented in terms of algorithms and symbolic representations of operations within a computer. These algorithmic descriptions and symbolic representations are the means used by those skilled in the data processing arts to convey the essence of their innovations to others skilled in the art. An algorithm is a series of defined steps leading to a desired end state or result. In example implementations, the steps carried out require physical manipulations of tangible quantities for achieving a tangible result.

Unless specifically stated otherwise, as apparent from the discussion, it is appreciated that throughout the description, discussions utilizing terms such as "processing," "computing," "calculating," "determining," "displaying," or the like, can include the actions and processes of a computer system or other information processing device that manipulates and transforms data represented as physical (electronic) quantities within the computer system's registers and memories into other data similarly represented as physical quantities within the computer system's memories or registers or other information storage, transmission or display devices.

Example implementations may also relate to an apparatus for performing the operations herein. This apparatus may be specially constructed for the required purposes, or it may include one or more general-purpose computers selectively activated or reconfigured by one or more computer programs. Such computer programs may be stored in a computer readable medium, such as a computer-readable storage medium or a computer-readable signal medium. A computer-readable storage medium may involve tangible mediums such as, but not limited to optical disks, magnetic disks, read-only memories, random access memories, solid state devices and drives, or any other types of tangible or non-transitory media suitable for storing electronic information. A computer readable signal medium may include mediums such as carrier waves. The algorithms and displays presented herein are not inherently related to any particular computer or other apparatus. Computer programs can involve pure software implementations that involve instructions that perform the operations of the desired implementation.

Various general-purpose systems may be used with programs and modules in accordance with the examples herein, or it may prove convenient to construct a more specialized apparatus to perform desired method steps. In addition, the example implementations are not described with reference to any particular programming language. It will be appreciated that a variety of programming languages may be used to implement the teachings of the example implementations as described herein. The instructions of the programming language(s) may be executed by one or more processing devices, e.g., central processing units (CPUs), processors, or controllers.

As is known in the art, the operations described above can be performed by hardware, software, or some combination of software and hardware. Various aspects of the example implementations may be implemented using circuits and logic devices (hardware), while other aspects may be implemented using instructions stored on a machine-readable medium (software), which if executed by a processor, would cause the processor to perform a method to carry out implementations of the present application. Further, some example implementations of the present application may be performed solely in hardware, whereas other example implementations may be performed solely in software. Moreover, the various functions described can be performed in a single unit, or can be spread across a number of components in any number of ways. When performed by software, the methods may be executed by a processor, such as a general purpose computer, based on instructions stored on a computer-readable medium. If desired, the instructions can be stored on the medium in a compressed and/or encrypted format.

Moreover, other implementations of the present application will be apparent to those skilled in the art from consideration of the specification and practice of the teachings of the present application. Various aspects and/or components of the described example implementations may be used singly or in any combination. It is intended that the specification and example implementations be considered as examples only, with the true scope of the present application being indicated by the following claims.

## Claims

**1.** A method for predicting failures and remaining useful life (RUL) for equipment, the method comprising:

for event-based sequential data received from the equipment comprising fault events, conducting feature extraction (110) on the event-based sequential data to generate data samples with sequences of event features based on the fault events;
executing data augmentation (120) on the data to increase the amount of data samples available for model training, the data augmentation (120) configured to generate additional semantically similar synthetic data samples based on the available data samples by using, within the generated sequences:

dropout of subsequences,
random injection of subsequences,
random shuffling or permutations of subsequences,
random variation in continuous features such that mean and variance of data distribution is maintained, and
value swap from nearby subsequences;

applying deep learning modeling (131-133) to the increased amount of data samples of sequences of event features to generate a model configured to predict the failures and the RUL for the equipment based on event features extracted from data of the equipment;
executing optimization (141-142) on the model, wherein the optimization (141-142) includes data-adaptive optimization (141) configured to weigh ones derived from the event-based sequential data received from the equipment higher than ones derived from the semantically similar data samples for the prediction of the failures and the RUL for the equipment; and
executing the model on data received from the equipment and controlling operation of the equipment based on the thereby predicted failures and RUL.

**2.** A non-transitory computer readable medium, storing instructions for predicting failures and remaining useful life (RUL) for equipment, the instructions comprising:

for event-based sequential data received from the equipment comprising fault events, conducting feature extraction (110) on the event-based sequential data to generate data samples with sequences of event features based on the fault events;
executing data augmentation (120) on the data to increase the amount of data samples available for model training, the data augmentation (120) configured to generate additional semantically similar synthetic data samples based on the available data samples by using, within the generated sequences:

dropout of subsequences,
random injection of subsequences,
random shuffling or permutations of subsequences,
random variation in continuous features such that mean and variance of data distribution is maintained, and
value swap from nearby subsequences;

applying deep learning modeling (131-133) to the increased amount of data samples of sequences of event features to generate a model configured to predict the failures and the RUL for the equipment based on event features extracted from data of the equipment;
executing optimization (141-142) on the model, wherein the optimization (141-142) includes data-adaptive optimization (141) configured to weigh ones derived from the event-based sequential data received from the equipment higher than ones derived from the semantically similar data samples for the prediction of the failures and the RUL for the equipment; and
executing the model on data received from the equipment and controlling operation of the equipment based on the thereby predicted failures and RUL.

**3.** The method of claim 1 or the non-transitory computer readable medium of claim 2, wherein the deep learning modeling (131-133) comprises learnable neural network-based attention mechanisms configured to determine relevant ones of the event features within the sequences of event features and discarding less relevant ones of the event features.

**4.** The method or non-transitory computer readable medium of claim 3, wherein the deep learning modeling (131-133) is one of multi-head attention (131), Long Short Term Memory (LSTM) (132), and ensemble modeling (133).

**5.** The method of claim 1 or the non-transitory computer readable medium of claim 2, wherein the optimization (141-142) of the model includes cost sensitive optimization (142) configured to weigh predictions of failures to be higher based on cost.

**6.** An apparatus configured to predict failures and remaining useful life (RUL) for equipment, the apparatus comprising: a processor (710), configured to:

for event-based sequential data received from the equipment comprising fault events, conduct feature extraction (110) on the event-based sequential data to generate data samples with sequences of event features based on the fault events;
apply deep learning modeling (131-133) to the sequences of event features to generate a model configured to predict the failures and the RUL for the equipment based on event features extracted from data of the equipment;
execute optimization (141-142) on the model; and
execute the model on data received from the equipment and control operation of the equipment based on the thereby predicted failures and RUL,
**characterized in that**
the processor (710) is configured to execute data augmentation (120) on the data to increase the amount of data samples available for model training, the data augmentation (120) configured to generate additional semantically similar synthetic data samples based on the available data samples by using, within the generated sequences:

dropout of subsequences,
random injection of subsequences,
random shuffling or permutations of subsequences,
random variation in continuous features such that mean and variance of data distribution is maintained, and
value swap from nearby subsequences,

the deep learning modeling (131-133) is applied to the increased amount of data samples of the sequences of event features, and
the optimization (141-142) includes data-adaptive optimization (141-142) configured to weigh ones derived from the event-based sequential data received from the equipment higher than ones derived from the semantically similar data samples for the prediction of the failures and the RUL for the equipment.

**7.** The apparatus of claim 6, wherein the deep learning modeling (131-133) comprises learnable neural network-based attention mechanisms configured to determine relevant ones of the event features within the sequences of event features and discarding less relevant ones of the event features.

**8.** The apparatus of claim 7, wherein the deep learning modeling (131-133) is one of multi-head attention (131), Long Short Term Memory (LSTM) (132), and ensemble modeling (133).

**9.** The apparatus of claim 6, wherein the optimization (141-142) of the model includes cost sensitive optimization (142) configured to weigh predictions of failures to be higher based on cost.

**Patentansprüche**

**1.** Verfahren zur Vorhersage von Ausfällen und der Restnutzungsdauer (RUL) von einem Gerät, wobei das Verfahren Folgendes umfasst:

für ereignisbasierte sequentielle Daten, die von dem Gerät empfangen werden und Fehlerereignisse umfassen, Durchführen einer Merkmalsextraktion (110) an den ereignisbasierten sequentiellen Daten, um Datenproben mit Sequenzen von Ereignismerkmalen auf der Grundlage der Fehlerereignisse zu erzeugen;
Ausführen einer Datenerweiterung (120) an den Daten, um die Menge der für das Modelltraining verfügbaren Datenproben zu erhöhen, wobei die Datenerweiterung (120) dazu konfiguriert ist, zusätzliche semantisch ähnliche synthetische Datenproben auf der Grundlage der verfügbaren Datenproben zu erzeugen, indem sie innerhalb der erzeugten Sequenzen verwendet:

Abbruch von Teilsequenzen,
zufälliger Einschub von Teilsequenzen,
Zufallsmischung oder Permutation von Teilsequenzen,
zufällige Variation in kontinuierlichen Merkmalen, so dass Mittelwert und Varianz der Datenverteilung erhalten bleiben, und
Werttausch aus nahe gelegenen Teilsequenzen;

Anwenden einer Deep-Learning-Modellierung (131-133) auf die erhöhte Menge von Datenproben von Sequenzen von Ereignismerkmalen, um ein Modell zu erzeugen, das dazu konfiguriert ist, die Ausfälle und die RUL für das Gerät auf der Grundlage von Ereignismerkmalen vorherzusagen, die aus Daten des Geräts extrahiert wurden;
Ausführen einer Optimierung (141-142) an dem Modell, wobei die Optimierung (141-142) eine datenadaptive Optimierung (141) umfasst, die dazu ausgelegt ist, diejenigen Daten, die aus den von dem Gerät empfangenen ereignisbasierten sequentiellen Daten abgeleitet sind, für die Vorhersage der Ausfälle und der RUL für das Gerät höher zu gewichten als diejenigen, die aus den semantisch ähnlichen Datenproben abgeleitet sind; und
Ausführen des Modells an den von dem Gerät empfangenen Daten und Steuern des Betriebs des Geräts auf der Grundlage der so vorhergesagten Ausfälle und RUL.

**2.** Nicht-transitorisches computerlesbares Medium, das Anweisungen zur Vorhersage von Ausfällen und der verbleibenden Nutzungsdauer (RUL) von einem Gerät speichert, wobei die Anweisungen Folgendes umfassen:

für ereignisbasierte sequentielle Daten, die von dem Gerät empfangen werden und Fehlerereignisse umfassen, Durchführen einer Merkmalsextraktion (110) an den ereignisbasierten sequentiellen Daten, um Datenproben mit Sequenzen von Ereignismerkmalen auf der Grundlage der Fehlerereignisse zu erzeugen;
Ausführen einer Datenerweiterung (120) an den Daten, um die Menge der für das Modelltraining verfügbaren Datenproben zu erhöhen, wobei die Datenerweiterung (120) dazu konfiguriert ist, zusätzliche semantisch ähnliche synthetische Datenproben auf der Grundlage der verfügbaren Datenproben zu erzeugen, indem sie innerhalb der erzeugten Sequenzen verwendet:

Abbruch von Teilsequenzen,
zufälliger Einschub von Teilsequenzen,
Zufallsmischung oder Permutation von Teilsequenzen,
zufällige Variation in kontinuierlichen Merkmalen, so dass Mittelwert und Varianz der Datenverteilung erhalten bleiben, und
Werttausch aus nahe gelegenen Teilsequenzen;

Anwenden einer Deep-Learning-Modellierung (131-133) auf die erhöhte Menge von Datenproben von Sequenzen von Ereignismerkmalen, um ein Modell zu erzeugen, das dazu konfiguriert ist, die Ausfälle und die RUL für das Gerät auf der Grundlage von Ereignismerkmalen vorherzusagen, die aus Daten des Geräts extrahiert wurden;
Ausführen einer Optimierung (141-142) an dem Modell, wobei die Optimierung (141-142) eine datenadaptive Optimierung (141) umfasst, die dazu ausgelegt ist, diejenigen Daten, die aus den von dem Gerät empfangenen ereignisbasierten sequentiellen Daten abgeleitet sind, für die Vorhersage der Ausfälle und der RUL für das Gerät höher zu gewichten als diejenigen, die aus den semantisch ähnlichen Datenproben abgeleitet sind; und
Ausführen des Modells an den von dem Gerät empfangenen Daten und Steuern des Betriebs des Geräts auf der Grundlage der so vorhergesagten Ausfälle und RUL.

**3.** Verfahren nach Anspruch 1 oder nicht-transitorisches computerlesbares Medium nach Anspruch 2, wobei die Deep-Learning-Modellierung (131-133) lernfähige, auf neuronalen Netzen basierende Aufmerksamkeitsmechanismen umfasst, die dazu konfiguriert sind, relevante der Ereignismerkmale innerhalb der Sequenzen von Ereignismerkmalen zu bestimmen und weniger relevante der Ereignismerkmale zu verwerfen.

**4.** Verfahren oder nicht-transitorisches computerlesbares Medium nach Anspruch 3, wobei die Deep-Learning-Modellierung (131-133) eine der folgenden ist: Multi-Head-Attention (131), Long-Short-Term-Memory (LSTM) (132) und Ensemble-Modellierung (133).

**5.** Verfahren nach Anspruch 1 oder nicht-transitorisches computerlesbares Medium nach Anspruch 2, wobei die Optimierung (141-142) des Modells eine kostensensitive Optimierung (142) umfasst, die dazu konfiguriert ist, Vorhersagen von Ausfällen mit höheren Kosten zu gewichten.

**6.** Vorrichtung, die dazu konfiguriert ist, Ausfälle und die Restnutzungsdauer (RUL) eines Geräts vorherzusagen, wobei die Vorrichtung Folgendes umfasst:
einen Prozessor (710), der dazu konfiguriert ist:

für ereignisbasierte sequentielle Daten, die von dem Gerät empfangen werden und Fehlerereignisse umfassen, eine Merkmalsextraktion (110) an den ereignisbasierten sequentiellen Daten durchzuführen, um Datenproben mit Sequenzen von Ereignismerkmalen auf der Grundlage der Fehlerereignisse zu erzeugen;
eine Deep-Learning-Modellierung (131-133) auf die Sequenzen von Ereignismerkmalen anzuwenden, um ein Modell zu erzeugen, das dazu konfiguriert ist, die Ausfälle und die RUL für das Gerät auf der Grundlage von Ereignismerkmalen vorherzusagen, die aus Daten des Geräts extrahiert wurden;
die Optimierung (141-142) für das Modell auszuführen; und
das Modell auf die von dem Gerät empfangenen Daten anzuwenden und den Betrieb des Geräts auf der Grundlage der so vorhergesagten Ausfälle und RUL zu steuern,
**dadurch gekennzeichnet, dass**
der Prozessor (710) dazu konfiguriert ist, eine Datenerweiterung (120) an den Daten auszuführen, um die Menge der für das Modelltraining verfügbaren Datenproben zu erhöhen, wobei die Datenerweiterung (120) dazu konfiguriert ist, zusätzliche semantisch ähnliche synthetische Datenproben auf der Grundlage der verfügbaren Datenproben zu erzeugen, indem er innerhalb der erzeugten Sequenzen verwendet:

Abbruch von Teilsequenzen,
zufälliger Einschub von Teilsequenzen,
Zufallsmischung oder Permutation von Teilsequenzen,
zufällige Variation in kontinuierlichen Merkmalen, so dass Mittelwert und Varianz der Datenverteilung erhalten bleiben, und
Werttausch aus nahe gelegenen Teilsequenzen,

die Deep-Learning-Modellierung (131-133) auf die erhöhte Menge an Datenproben der Sequenzen von Ereignismerkmalen angewandt wird, und
die Optimierung (141-142) eine datenadaptive Optimierung (141-142) umfasst, die dazu ausgelegt ist, diejenigen Daten, die aus den von dem Gerät empfangenen ereignisbasierten sequentiellen Daten abgeleitet sind, für die Vorhersage der Ausfälle und der RUL höher gewichtet als diejenigen, die aus den semantisch ähnlichen Datenproben das Gerät abgeleitet sind.

**7.** Vorrichtung nach Anspruch 6, wobei die Deep-Learning-Modellierung (131-133) lernfähige, auf neuronalen Netzen basierende Aufmerksamkeitsmechanismen umfasst, die dazu konfiguriert sind, relevante der Ereignismerkmale innerhalb der Sequenzen von Ereignismerkmalen zu bestimmen und weniger relevante der Ereignismerkmale zu verwerfen.

**8.** Vorrichtung nach Anspruch 7, wobei es sich bei der Deep-Learning-Modellierung (131-133) um eine der folgenden handelt: Multi-Head-Attention (131), Long-Short-Term-Memory (LSTM) (132) und Ensemble-Modellierung (133).

**9.** Vorrichtung nach Anspruch 6, wobei die Optimierung (141-142) des Modells eine kostensensitive Optimierung (142) umfasst, die dazu konfiguriert, Vorhersagen von Ausfällen mit höheren Kosten zu gewichten.

## Revendications

**1.** Procédé de prédiction de défaillances et de durée de vie utile restante (RUL) pour un équipement, le procédé comprenant :

pour des données séquentielles basées sur les événements reçues de l'équipement comprenant des événements de pannes, la conduite d'une extraction (110) de caractéristiques sur les données séquentielles basées sur les événements pour générer des échantillons de données avec des séquences de caractéristiques d'événements basées sur les événements de pannes ;
l'exécution d'une augmentation (120) de données sur les données pour accroître la quantité d'échantillons de données disponibles pour un apprentissage de modèle, l'augmentation (120) de données configurée pour générer des échantillons de données synthétiques additionnels sémantiquement similaires basés sur les échantillons de données disponibles en utilisant, au sein des séquences générées :

un abandon de sous-séquences,
une injection aléatoire de sous-séquences,
un réarrangement ou des permutations aléatoire(s) de sous-séquences,
une variation aléatoire de caractéristiques continues de telle sorte qu'une moyenne et une variance de distribution de données sont maintenues, et
une interversion de valeurs à partir de sous-séquences proches ;

l'application d'une modélisation d'apprentissage profond (131-133) à la quantité accrue d'échantillons de données de séquences de caractéristiques d'événements pour générer un modèle configuré pour prédire les défaillances et la RUL pour l'équipement sur la base de caractéristiques d'événements extraites de données de l'équipement ;
l'exécution d'une optimisation (141-142) sur le modèle, dans lequel l'optimisation (141-142) inclut une optimisation adaptative en données (141) configurée pour pondérer celles obtenues à partir des données séquentielles basées sur les événements reçues de l'équipement à un niveau supérieur par rapport à celles obtenues à partir des échantillons de données sémantiquement similaires pour la prédiction des défaillances et de la RUL pour l'équipement ; et

l'exécution du modèle sur des données reçues de l'équipement et la commande du fonctionnement de l'équipement sur la base des défaillances et de la RUL ainsi prédites.

**2.** Support non transitoire lisible par ordinateur, stockant des instructions pour la prédiction de défaillances et de durée de vie utile restante (RUL) pour un équipement, les instructions comprenant :

pour des données séquentielles basées sur les événements reçues de l'équipement comprenant des événements de pannes, la conduite d'une extraction (110) de caractéristiques sur les données séquentielles basées sur les événements pour générer des échantillons de données avec des séquences de caractéristiques d'événements basées sur les événements de pannes ;
l'exécution d'une augmentation (120) de données sur les données pour accroître la quantité d'échantillons de données disponibles pour un apprentissage de modèle, l'augmentation (120) de données configurée pour générer des échantillons de données synthétiques additionnels sémantiquement similaires basés sur les échantillons de données disponibles en utilisant, au sein des séquences générées :

un abandon de sous-séquences,
une injection aléatoire de sous-séquences,
un réarrangement ou des permutations aléatoire(s) de sous-séquences,
une variation aléatoire de caractéristiques continues de telle sorte qu'une moyenne et une variance de distribution de données sont maintenues, et
une interversion de valeurs à partir de sous-séquences proches ;

l'application d'une modélisation d'apprentissage profond (131-133) à la quantité accrue d'échantillons de données de séquences de caractéristiques d'événements pour générer un modèle configuré pour prédire les défaillances et la RUL pour l'équipement sur la base de caractéristiques d'événements extraites de données de l'équipement ;
l'exécution d'une optimisation (141-142) sur le modèle, dans lequel l'optimisation (141-142) inclut une optimisation adaptative en données (141) configurée pour pondérer celles obtenues à partir des données séquentielles basées sur les événements reçues de l'équipement à un niveau supérieur par rapport à celles obtenues à partir des échantillons de données sémantiquement similaires pour la prédiction des défaillances et de la RUL pour l'équipement ; et
l'exécution du modèle sur des données reçues de l'équipement et la commande du fonctionnement de l'équipement sur la base des défaillances et de la RUL ainsi prédites.

**3.** Procédé selon la revendication 1 ou support non transitoire lisible par ordinateur selon la revendication 2, dans lequel la modélisation d'apprentissage profond (131-133) comprend des mécanismes d'attention basés sur un réseau neuronal doté d'une capacité d'apprentissage configurés pour déterminer celles pertinentes parmi les caractéristiques d'événements au sein des séquences de caractéristiques d'événements et rejeter celles moins pertinentes parmi les caractéristiques d'événements.

**4.** Procédé ou support non transitoire lisible par ordinateur selon la revendication 3, dans lequel la modélisation d'apprentissage profond (131-133) est une parmi une modélisation d'attention à têtes multiples (131), de mémoire à long et court terme (LSTM) (132), et d'ensembles (133).

**5.** Procédé selon la revendication 1 ou support non transitoire lisible par ordinateur selon la revendication 2, dans lequel l'optimisation (141-142) du modèle inclut une optimisation (142) sensible au coût configurée pour pondérer des prédictions de défaillances pour qu'elles soient plus élevées sur la base du coût.

**6.** Appareil configuré pour prédire des défaillances et la durée de vie utile restante (RUL) pour un équipement, l'appareil comprenant :
un processeur (710), configuré pour :

pour des données séquentielles basées sur les événements reçues de l'équipement comprenant des événements de pannes, conduire une extraction (110) de caractéristiques sur les données séquentielles basées sur les événements pour générer des échantillons de données avec des séquences de caractéristiques d'événements basées sur les événements de pannes ;
appliquer une modélisation d'apprentissage profond (131-133) aux séquences de caractéristiques d'événements pour générer un modèle configuré pour prédire les défaillances et la RUL pour l'équipement sur la base de caractéristiques d'événements extraites de données de l'équipement ;
exécuter une optimisation (141-142) sur le modèle ; et
exécuter le modèle sur des données reçues de l'équipement et commander le fonctionnement de l'équipement sur la base des défaillances et de la RUL ainsi prédites,
**caractérisé en ce que**
le processeur (710) est configuré pour exécuter une augmentation (120) de données sur les données pour accroître la quantité d'échantillons de données disponibles pour un apprentissage de modèle, l'augmentation (120) de données configurée pour générer des échantillons de données synthétiques additionnels sémantiquement similaires basés sur les échantillons de données disponibles en utilisant, au sein des séquences générées :

un abandon de sous-séquences,
une injection aléatoire de sous-séquences,
un réarrangement ou des permutations aléatoire(s) de sous-séquences,
une variation aléatoire de caractéristiques continues de telle sorte qu'une moyenne et une variance de distribution de données sont maintenues, et
une interversion de valeurs à partir de sous-séquences proches,

la modélisation d'apprentissage profond (131-133) est appliquée à la quantité accrue d'échantillons de données des séquences de caractéristiques d'événements, et
l'optimisation (141-142) inclut une optimisation adaptative en données (141-142) configurée pour pondérer celles obtenues à partir des données séquentielles basées sur les événements reçues de l'équipement à un niveau supérieur par rapport à celles obtenues à partir des échantillons de données sémantiquement similaires pour la prédiction des défaillances et de la RUL pour l'équipement.

**7.** Appareil selon la revendication 6, dans lequel la modélisation d'apprentissage profond (131-133) comprend des mécanismes d'attention basés sur un réseau neuronal doté d'une capacité d'apprentissage configurés pour déterminer celles pertinentes parmi les caractéristiques d'événements au sein des séquences de caractéristiques d'événements et rejeter celles moins pertinentes parmi les caractéristiques d'événements.

**8.** Appareil selon la revendication 7, dans lequel la modélisation d'apprentissage profond (131-133) est une parmi une modélisation d'attention à têtes multiples (131), de mémoire à long et court terme (LSTM) (132), et d'ensembles (133).

**9.** Appareil selon la revendication 6, dans lequel l'optimisation (141-142) du modèle inclut une optimisation (142) sensible au coût configurée pour pondérer des prédictions de défaillances pour qu'elles soient plus élevées sur la base du coût.

Preprocessing 100
Feature Extraction 110
Data Augmentation 120
Multihead Attention 131
LSTM 132
Ensemble 133
Modeling
Data-adaptive Optimization 141
Cost-sensitive optimization 142
Optimization

FIG. 1

| Event # | 1 | 2 | 3 | 4 | 5 | 6 | 7 | 8 | 9 | 10 | Failure |
|---|---|---|---|---|---|---|---|---|---|---|---|
| Event, Odometer | (E1, 5000) | (E2, 5200) | (E1, 5300) | (E3, 5900) | (E3, 7000) | (E4, 7000) | (E3, 7500) | (E4, 9900) | (E4, 9950) | (E4, 10K) | 10K miles |
| Miles to Fail | (E1, 5000) | (E2, 4800) | (E1, 4700) | (E3, 4100) | (E3, 3000) | (E4, 3000) | (E3, 2500) | (E4, 100) | (E4, 50) | (E4, 0) | |
| Bucketizing | (E1, B4) | (E2, B4) | (E1, B4) | (E3, B4) | (E3, B3) | (E4, B3) | (E3, B3) | (E4, B1) | (E4, B1) | (E4, B1) | |
| Reassigning | (E1, B4) | (E2, B4) | (E1, B4) | (E3, B4) | (E3, B3) | (E4, B3) | (E3, B4) | (E4, B1) | (E4, B1) | (E4, B1) | |

| Sequences | | | | |
|---|---|---|---|---|
| | (E1, B4) | | | |
| | (E1, B4) | (E1, B4) | | |
| | (E1, B4) | (E1, B4) | (E3, B4) | |
| | (E1, B4) | (E1, B4) | (E3, B4) | (E3, B4) |
| | (E1, B4) | (E3 B4) | (E3, B4) | (E3, B4) |
| | (E2, B4) | | | |
| | (E2, B4) | (E4, B3) | | |
| | (E2, B4) | (E4, B3) | (E4, B1) | |
| | (E2, B4) | (E4, B3) | (E4, B1) | (E4, B1) |
| | (E4, B3) | (E3 B1) | (E4, B1) | (E4, B1) |

FIG. 2

Sequence of events 301
Integer encoding 310
Embedding 320
Event count 302
One-hot encoding 311
Distance since last failure 303
Distance since event is on 304
Distance since last event 305
Unit attributes 306
One-hot encoding 311
Concatenate 330
LSTM 340
Dense 350
Softmax 360

FIG. 3

Sequence of events 300
Event count 301
Distance since last failure 302
Distance since event is on 303
Distance since last event 304
Unit attributes 305
Integer encoding 310
One-hot encoding 311
One-hot encoding 311
Embedding 320
Concatenate 330
Multi-head Attention 400
Dense 350
Softmax 360

FIG. 4

Sequence of events 300
Unit attributes 301
Event count 302
Distance since last failure 303
Distance since event is on 304
Distance since last event 305
Integer encoding 310
One-hot encoding 311
One-hot encoding 311
TFIDF feature extraction 503
Embedding 320
Concatenate 330
Concatenate 330
DNN 500
1D CNN 501
LSTM 340
Dense 350
Dense 350
Dense 350
Softmax 360
Softmax 360
Softmax 360
Prediction output
Prediction output
Prediction output
Majority Voting 504
Final Output 505

FIG. 5

601-1
601-2
601-3
601-4
Network
600
602
Database
603

FIG. 6

700
INPUT/USER INTERFACE 735
OUTPUT DEVICE/ INTERFACE 740
EXTERNAL STORAGE 745
NETWORK 750
COMPUTING DEVICE 705
I/O INTERFACE 725
INTERNAL STORAGE 720
MEMORY 715
730
PROCESSOR(S) 710
LOGIC UNIT 760
API UNIT 765
INPUT UNIT 770
OUTPUT UNIT 775
795

FIG. 7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 2020210824 A1
- US 2016239756 A1
- US 2018356151 A1
- EP 3407267 A1
- WO 2018071005 A1
- US 2019235484 A1